# EUROPEAN PATENT APPLICATION

(11) **EP 1 339 108 A1**
(43) Date of publication of application: **27.08.2003**
(21) Application number: 02251154.7
(22) Date of filing: 20.02.2002
(51) Int. Cl.: H01L 33/00, H01S 5/227

(54) **Semiconductor device with current confinement structure**

(71) Applicant: Agilent Technologies, Inc. - a Delaware corporation -, Palo Alto, CA 94303-0870 (US)
(72) Inventor: The designation of the inventor has not yet been filed
(74) Representative: Coker, David Graeme

(57) **Abstract**

The present invention relates to a semiconductor device (1) with one or more current confinement regions (20) and to a method of manufacturing such a device, particularly buried heterostructure light emitting devices such as semiconductor lasers and light emitting diodes. The device comprises a substrate (2), a buried heterojunction active layer (10) above said substrate, a current conduction region (4) above the active layer (10), one or more current confinement regions (20;120) formed over the substrate (2), and at least one trench (25;125) formed in the current confinement region(s). The trench extends through said current confinement region(s) (20;120) towards the substrate (2), and the or each current confinement region is bounded on one side by the active layer (10), and on another side by said trench(es) (25;125). The current confinement region(s) (20;120) and current conduction region (4) are arranged in use to channel electric current (5) to the active layer (10). The or each current confinement region (20;120) includes a non-semiconducting insulating layer (19';119') that extends from the or each trench (25;125) towards the active layer (10) to restrict the flow of current (5) through the current confinement region (20;120).

## Description

The present invention relates to a semiconductor device with one or more current confinement regions and to a method of manufacturing such a device, particularly buried heterostructure light emitting devices such as semiconductor lasers and light emitting diodes.

The fabrication and use of laser diodes in a buried heterostructure was achieved many years ago. In the field of transmitter devices for fibre-optic communication, operation is required from 1.3 to 1.6 µm, and so such opto-electronic transmitter devices are usually fabricated from a wafer grown from an n-InP substrate on which are grown a number of layers, including an undoped InGaAsP active layer, which may be either a bulk semiconductor or a multiple quantum well or dot structure sandwiched between an upper p-InP cladding layer and a lower n-InP buffer layer. A mask is applied to the upper cladding layer, and the surrounding layers are etched to leave a mesa structure. Buried heterostructure light emitting devices commonly have current confinement regions defined by areas of high resistivity or of other means to limit current flow that are grown to cover the sides of the mesa and which channel current to an optically active layer within the mesa structure.

A mask defining the mesa is then removed, and further layers are grown up to a p⁺-InGaAs ternary cap layer. The ternary cap layer has a relatively low resistance and narrow bandgap facilitating electrical contact, and so serves as a contact layer to which electrical contacts may be made.

In devices using InGaAsP/InP materials, current confinement regions have often been employed based on a reverse-biased p-n or n-p diode structure. Such structures provide high resistance to current flow, and low leakage currents, and are widely used in fibre optic communication systems across a range of operating frequencies and temperatures. At operating frequencies about 1 GHz, and particularly at higher operating temperatures, the performance of such devices becomes limited by the capacitance of the current blocking structure.

The static performance of such buried heterostructure devices having p-n (or equivalently n-p) reverse-biased current-blocking structures, and particularly the leakage currents, and slope efficiencies, has been shown to depend on the properties of the current leakage path through the current blocking layers. The maximum modulation speed, for high frequency operation depends mainly on the capacitance of such layers.

In recent years there has been an increasing demand for fibre optic communication links having a bandwidth in excess of 1 GHz, for example up to 10 GHz. It is an object of the present invention to provide a semiconductor device that addresses these issues.

Accordingly, the invention provides a semiconductor device, comprising a substrate, a buried heterojunction active layer above said substrate, a current conduction region above the active layer, one or more current confinement regions formed over the substrate, at least one trench formed in the current confinement region(s), said trench extending through said current confinement region(s) towards the substrate and the or each current confinement region being bounded on one side by the active layer, and on another side by said trench(es) and the current confinement region(s) and current conduction region being arranged in use to channel electric current to the active layer, wherein the or each current confinement region includes a non-semiconducting essentially insulating layer that extends from the or each trench towards the active layer to restrict the flow of current through the current confinement region.

The device may have a contact layer above the current conduction region in order to inject current into the active layer. The trench can serve to limit conduction of current laterally away from the device. Because the insulating layer extends from close to the active layer to the trench, the insulating layer can then effectively block or at least inhibit the flow of current in the current confinement region past the active layer.

Although the active layer may have some inherent capacitance, this can be made less than the capacitance of similarly low conductivity reverse biased semiconductor p-n junctions. The insulating layer therefore helps to improve the electrical efficiency of the device, as well as the high frequency performance.

In one embodiment of the invention, the insulating layer is formed from one or more voids in the current confinement region. The void may during manufacture be filled with an inert, dry gas, in order to avoid potential oxidation and subsequent degradation of surrounding semiconductor layers.

In an alternative embodiment of the invention, the insulating layer is formed from an oxidised aluminium bearing layer. It is preferable if the layer is not formed from pure aluminium oxide, but rather a composition containing enough aluminium to make the layer essentially insulating, i.e. ideally with a resistivity of at least 10⁵ ohm-cm.

In order to help stabilise the insulating layer physically and/or chemically, it is preferred if the insulating layer is capped at the of each trench by a passivating layer deposited over said trench(es). The cap lay is preferably formed from a material that is a good insulator and barrier to water vapour and oxygen, for example silicon nitride or oxide.

In the preferred embodiments of the invention, the device includes a buried mesa structure having one or more side walls that rise above the substrate, with the active layer extending to the side wall(s) and the active layer being proximate the insulating layer. Preferably, the insulating layer is level with the active layer with respect to the direction of the current flow through the current conduction region.

Also according to the invention, there is provided a method of forming semiconductor device comprising an active layer, a current conduction region, and one or more current confinement regions, the or each current confinement region being bounded on one side by the active layer and the current conduction region(s) and current confinement region being arranged in use to channel electric current to the active layer, wherein the method comprises the steps of:
i) growing upon a semiconductor substrate a plurality of semiconductor layers, including the active layer and the current conduction region by which electric current may be applied to the active layer;
ii) growing adjacent the active layer a current blocking structure, said structure being formed from a plurality of semiconductor layers;
iii) forming at least one trench in the current confinement structure towards the substrate to expose within said structure one or more of said plurality of semiconductor layers;
iv) applying a reagent to said exposed semiconductor layer(s) in order to transform said one or more of said layer(s) into a non-semiconductor insulating layer, said insulating layer in use restricting the flow of current through the current confinement structure.

In the preferred embodiments of the invention, the reagent reacts with one or more of said exposed semiconductor layers starting at the trench and moving towards the active layer. This is particularly advantageous in that the reaction can be self-limiting in the sense that the reaction stops just before the boundary between the current confinement structure and the active layer. The formation of the insulating layer and its closeness to the active layer is then made much less sensitive to the particular process condition, depending more on the structure of the current blocking layers than the reaction process which helps to improve yield and lower device cost.

In one embodiment of the invention, the insulating layer is formed from one or more voids in the current confinement region, and the method includes the step of using the reagent to etch away at least partially one or more of said exposed semiconductor layers to produce the void(s).

In an alternative embodiment of the invention, the exposed semiconductor layer(s) includes an aluminium-bearing semiconductor composition and said insulating layer, and the method includes the step of using said reagent to oxidise at least partially the aluminium-bearing composition to produce an aluminium oxide insulating layer.

In or to help protect the insulating layer, it is preferred if following step iv) the method includes the step of depositing over the or each trench a passivating layer.

Because the insulating layer is a non-semiconductor layer also, this also presents a further barrier to changes in the chemical composition adjacent semiconductor layers, for example by migration of dopants between layers. The insulating layer therefore helps to reduce any changes in the composition of the current confinement region or current conduction region that would tend to reduce the static or dynamic performance of the device.

Preferably, the thickness of the current confinement structure is between 400 nm and 2 µm, and the thickness of the insulating layer is between 50 nm and 250 nm.

Because the substrate may be formed from a boule that has a certain level of undesirable lattice defects, it is preferred if the device includes between the substrate and the non-semiconductor insulating layer, a semiconductor "buffer" layer grown on the substrate. Such a grown "buffer" layer can be formed with a lower level of defects than the underlying substrate, thereby improving the ability of the current confinement region to block current.

The device may include a buried mesa structure having one or more side walls that rise above the substrate. The active layer may then extend to the or each side wall. It is then preferred if the active layer contacts to insulating layer.

This reduces optical losses and results in lower threshold current and increased slope efficiency.

The invention will now be described by way of example, with reference to the accompanying drawings, in which:
Figure 1 is a schematic cross-section of a buried heterostructure semiconductor laser device according to a first embodiment of the invention, comprising an active layer within a buried mesa stripe, a current conduction region for channelling current to the active layer, and a pair of current confinement regions each of which has an insulating layer formed from oxidised aluminium bearing composition;
Figures 2 to 4 show process steps for creating the semiconductor laser device according to the first embodiment of the invention; and
Figure 5 is a schematic cross-section of a buried heterostructure semiconductor laser device according to a second embodiment of the invention, similar to that of the first embodiment, but with an insulating layer in the form of an insulating void within each of the current confinement regions.

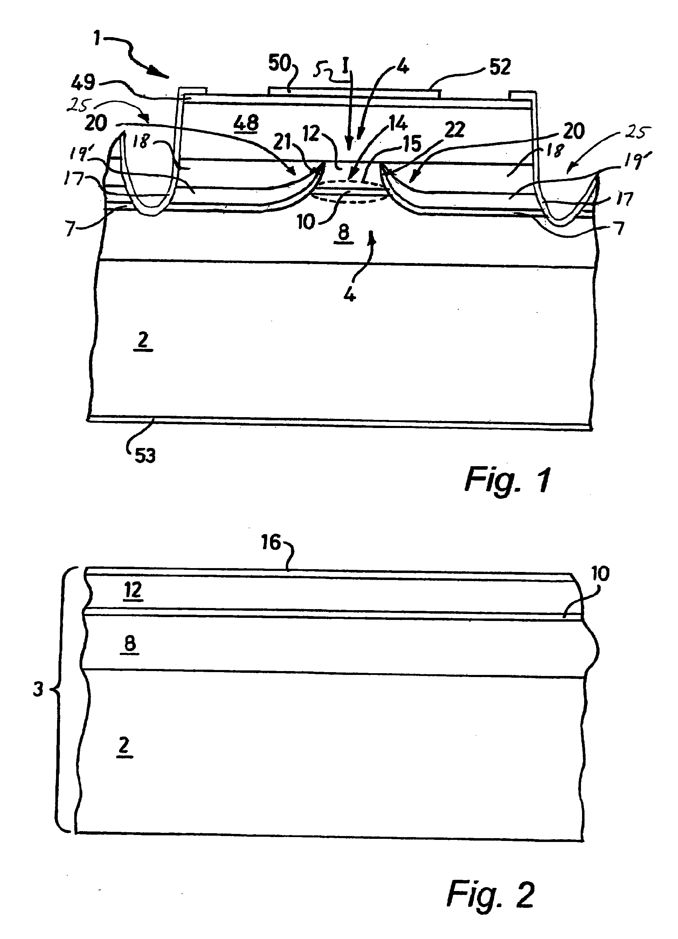

Figure 1 shows, not to scale, a cross-section of a III-V semiconductor device 1 according to a first embodiment of the invention, here a buried heterostructure laser diode suitable for use as a transmitter in a high speed fibre-optic link operating between 1.27 and 1.6 µm. Currently, high speed links operate at 1, 2.5 or 10 Gbits/s.

Referring now also to Figure 2, the device 1 is formed starting from a wafer 3 that is around 50 mm in diameter , and that has an n-InP substrate 2 doped to around 10¹⁹ cc⁻¹, on which is grown a number of n-type and p-type

III-V semiconductor layers, using well-known MOCVD techniques. The p-type dopant is zinc, and the n-type dopant is sulphur.

The first grown layer is a 2 µm thick n⁻ - InP buffer layer 8 doped to around 10¹⁸ cc⁻¹. An active layer 10 is grown on the buffer layer 8 according to known techniques for fabricating planar active lasers for a laser diode - the active layer could be a bulk region or a strained multiple quantum well (SMQW) structure. An example of an SMQW device is discussed in W. S. Ring et al, Optical Fibre Conference, Vol. 2, 1996 Technical Digest Series, Optical Society of America. The type of active layer employed is not critical to the invention.

In the present example, the laser diode 1 has a quaternary InₓGa₁₋ₓAs_{1-y}P_{y} active layer 10 that may be between about 100 nm to 300 nm thick. The active layer 10 is topped by a cladding layer 12, formed from p⁺-InP, grown to be between about 100 nm to 1 µm thick.

Although not illustrated a DFB grating for the laser diode 1 can be contained in the n-InP buffer layer 8 or in the p-InP cladding layer 12 by forming a periodically etched layer of a material such as GaInAsP.

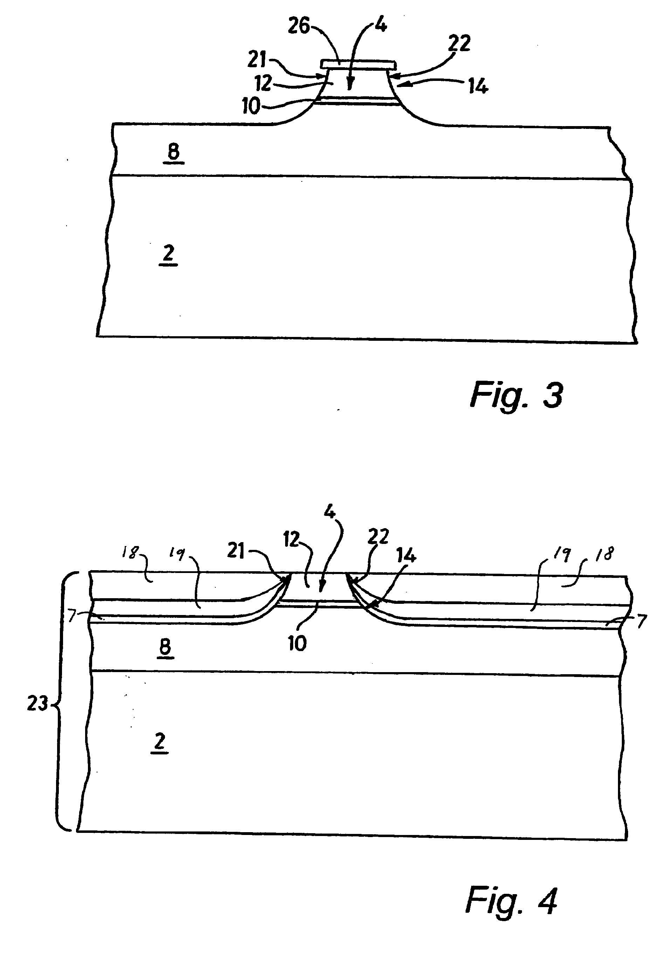

Then, using well-known fabrication technology, the wafer 3 is coated with an oxide layer 16 as shown in Figure 2. The oxide layer may be SiO₂ deposited by a plasma enhanced chemical vapour deposition (PECVD) process. It should, however, be noted that silicon nitride would be a suitable alternative choice to SiO₂. As shown in Figure 3, the oxide layer 16 is photolithographically patterned with a photoresist to leave a patterned mask 26, and etched to remove, in areas not covered by the patterned mask, the cladding layer 12, the active layer 10, and part of the buffer layer 8. In this example layers 8, 10 and 12 are removed in a wet-etch process that undercuts the patterned mask 26. It would, however, be possible to use a reactive ion dry etching process.

The grown layers 8,10 and 12 are removed in all areas except along a mesa stripe 14 structure that extends perpendicular to the plane of the drawing, and which rises above the level of the substrate 2. The mesa stripe 14 has left and right opposite side walls 21,22 that together with the buffer layer 8 and the cladding 12 form a current conduction region 4 for an applied current 5 (I), and have the effect of guiding an optical mode 15 along the active layer 10 within the stripe 14.

The wet etch process produces mesa side walls 21,22 that slope laterally away from the active layer. A dry etch process would produce side walls that are more closely vertical.

The width of the mesa stripe 14 varies depending on the particular device, but for opto-electronic devices such as laser diodes, the ridge stripe 14 is usually between 1 µm and 3 µm wide. The ridge strip 14 rises 1 µm to 2 µm above the surrounding substrate 2.

A current confinement or blocking structure 20 is then grown on the etched device up to approximately the level of the patterned mask 26. The structure 20 includes a number of layers adjacent the buffer layer 8 including a first p-doped InP layer 7 having a dopant concentration about 1x10¹⁸ cc ⁻¹ and above this, aluminium-bearing semiconductor layer 19, for example a superlattice of alternating AlAs and InAs layers. The structure 20 is completed with an n-doped InP layer 18, having a dopant concentration of at least about 1x10¹⁸ cc⁻¹, grown above the aluminium bearing layer 19. The n-doped InP layer 18 preferably has a substantially constant dopant concentration at least as high as the highest dopant concentration in the p-type layer 7.

The thicknesses of the n-doped layer 18 is about 0.5 µm and the thickness of the p-doped layer 7 is about 0.4 µm. These InP layers 7,18 form a p-n junction that in use is reverse biased and hence insulating when the conduction region 4 is forward biased.

The p-doped layer 7 should be between about one-tenth and one-half the thickness of the n-doped layer 18, that is between about 50 nm and about 250 nm thick.

After deposition of the semiconductor layers 7,18,19 used to form the current blocking structure 20, the PECVD oxide layer 16 is removed with 10:1 buffered HF from the ridge strip 14 to expose again the cladding layer 12. This leaves an etched and coated wafer 23 comprising the substrate 2, the mesa stripe 14 and the layers 7,18,19 abutting the opposite sides 21,22 of the mesa stripe 14.

A cladding layer 46 formed from highly doped p⁺-InP is then grown above the cladding layer 12 and the layers 7,18,19 used to form the current blocking structure 20, up to a thickness of about 2 µm to 3 µm. The final semiconductor layer is a 100 nm to 200 nm thick ternary cap layer 49 deposited on the cladding layer 48. The cap layer 49 is formed from p⁺⁺-GaInAs, very highly doped to greater than 10¹⁹ cc⁻¹, in order to provide a good low resistance ohmic contact for electrical connection to the current conduction region 4 of the mesa stripe 14. As an alternative to a ternary cap layer, it is possible to use a quaternary InGaAsP cap layer, or both InGaAsP and InGaAs layers.

During processing of grown layers 18,19,48,49 above the graded layer 7, the device 1 may experience temperatures as high at 650 °C.

This leaves an etched and overgrown wafer 28 comprising the substrate 2, the mesa stripe 14, the layers 7,18,19 abutting the opposite sides 21,22 of the mesa stripe 14, and the overlying cladding and cap layers 46,49.

Then, the wafer 28 is coated with an oxide layer 48 as shown in Figure 4. The oxide layer may be SiO₂ deposited by a plasma enhanced chemical vapour deposition (PECVD) process. It should, however, be noted that silicon nitride would be a suitable alternative choice to SiO₂. As shown in Figure 4, the oxide layer 48 is photolithographically patterned with a photoresist to create gaps 51 in the oxide layer 48. The gaps 51 are stripes that run parallel to the mesa strip 14, laterally away from the mesa side walls 21,22.

The wafer 28 is then deeply etched in a wet-etch process to remove, in areas not covered by the oxide mask 48, the cap layer 49, cladding layer 48, n-doped layer 19, aluminium bearing layer 19, the graded first p-doped layer 7, and all but 100 nm of the underlying buffer layer 8, thus forming a pair of parallel stripe trenches 25 either side of the buried mesa stripe 14. Again, it would be possible to form the trench using a reactive ion dry etching process.

The etched mesa 28 is then exposed to hot steam and air, for example at 450°C for 5 minutes. The steam and air act as a reagent to cause the aluminium bearing superlattice 19 to oxidise, starting at the trench, and moving inwards towards the mesa stripe 14 and active layer 10. This oxidation process is inherently self-limiting, in that the oxidation stops when the layer 19 has been fully oxidized up to the buried mesa 14, as indicated by reference numeral 19'. The insulating aluminium oxide bearing layer 19' created by the process is also inherently aligned with the mesa stripe 14.

In this example, the insulating layer 19' is adjacent to and slightly above the active layer. Any small gap between the insulating layer 19' and active layer 10 is minimised by the formation of the current confinement structure 7,18,19, which grows right up against the side walls 21,22 of the mesa strip 14. The result is a highly insulating structure with low parasitic capacitance, owing to the reduced dielectric constant of the oxidised layer 19' compared with the unoxidised layer 19.

An aluminium oxide, silicon oxide, or silicon nitride passivating layer 17 is then deposited, again using a standard photolithographic process, to cover the trenches 25 to protect the current confinement structure 7,18,19, and particularly the insulating layer 19. It should be noted, however, that alignment of the passivating layer 17 is not critical as long as it covers over the trench side walls.

Standard metal layers 50 for electrical contact to the buried heterostructure are then vacuum deposited on the cap layer 49 using well known techniques, followed by metal wet etch in photolithographically defined areas. The remaining metal forms a contact pad 52 with good ohmic contact through the cap layer 49.

Optionally, the metal layers 50 may be deposited before the deposition of the passivating layer 17.

The resulting wafer is then thinned to a thickness of about 70 µm to 100 µm in a standard way, in order to assist with cleaving. Standard metal layers 53 are then deposited by sputtering on the rear surface of the wafer, so enabling electrical contact to be made to the n-side of the devices.

The wafer is then inscribed and cleaved in a conventional process first transversely into bars about 350 µm wide, and then each bar is cleaved into individual devices 200 µm wide. The cleaved device 1 is about 350 µm long (i.e. in the direction of the mesa 14) and about 200 µm wide.

Although not shown, after testing the device 1 may be packaged in an industry standard package, with a single mode optical fibre coupled with a spherical lens to an output facet of the laser diode, and with gold bond wires thermal compression bonded onto the metalised contact 52.

The InGaAsP/InP device 1 described above therefore incorporates a current confinement region formed from a reverse-biased p-n structure 7,18 together with an insulating layer 19 formed within the junction. Therefore, as will be described in further detail below, the first embodiment of the invention provides a low conductivity current confinement region 20, and low leakage currents, across a wide range of operating temperatures. The invention also permits the use of higher drive currents, which are useful in achieving high-speed operation.

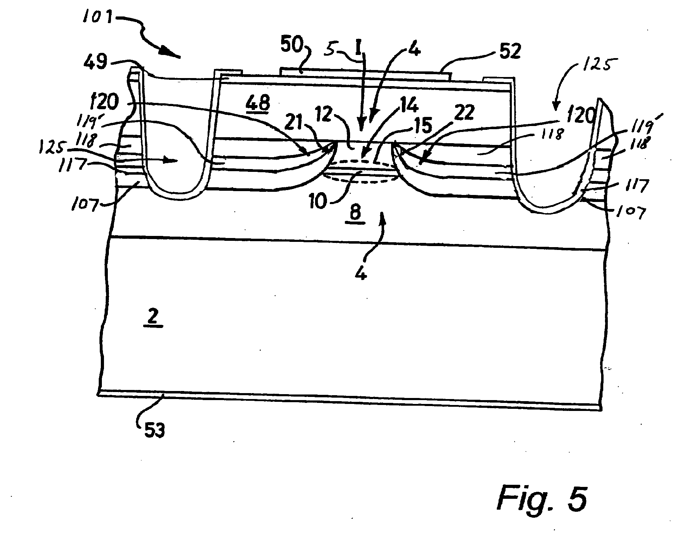

Figure 5 shows how the process described above may be modified, in a second embodiment 101 of the invention, where features corresponding with those of Figures 1 to 4 are given similar reference numerals incremented by 100. The process used to create the second embodiment 101 differs from that used to create the first embodiment 1 in that in place of the aluminium bearing semiconductor layer, an etchable layer 119 is formed between the lower p-type layer 107 and upper n-type layer 118.

Once the trenches 125 have been formed, the etchable layer 119 is etched away in a wet etch process to leave a void 119' in the current confinement region 120. Optionally, the void may be filled passively with a dry inert gas to minimise subsequent aging of the device.

The etchable layer 119 is preferably formed from a semiconductor material, for example GaInAs which can subsequently be etched away in a second wet etch stage wherein the reagent used for etching is chosen to etch GaInAs but to leave the surrounding InP layers intact. A suitable etchant is sulphuric acid in combination with hydrogen peroxide and water Alternatively, the trenches 125 can be formed in a dry etch process, and the etchable layer 119 then removed in a wet etch process.

The trenches 125 and voids 119' are then protected with a passivating layer 117, as described above.

In both embodiments 1,101, there is one non-semiconducting insulating layer 19',119' that extends from each trench 25,125 towards the active layer 10 to restrict the flow of current 5 through the current confinement region 20,120.

Semiconductor devices according to the invention provide a high operating bandwidth and good lifetime characteristics. The process steps involved may be similar to other standard steps used in the fabrication of such devices. There is no need for additional expensive processing equipment.

Although the present invention has been described specifically for the example of a laser diode, the invention is applicable to any high speed semiconductor device where current blocking regions help to channel current through a current conduction region, for example ridge waveguide type lasers, pump lasers, edge emitting light emitting diodes, , surface emitting laser and light emitting diodes. Another example is an optical waveguide with a split into two waveguides at a Y-junction. This may have electrically driven or modulated active optical regions in two or three of the arms of the "Y", for example an optical amplifier or modulator. It may then be desirable to provide a current blocking region at the junction of the three arms, where there may be three separate conduction regions.

The invention may also be used with additional current blocking layers, for example above the blocking regions previously discussed.

The invention described above has been described for a device based on an n-InP substrate, having a first current blocking structure formed from a reverse biased p-n junction in laterally adjacent contact with the active layer structure. However, it is to be appreciated that the invention can also be applied to other types of devices, for example those based on a p-InP substrate. In this case, the first current blocking layer would be formed from an n-type material.

## Claims

1. A semiconductor device (1,101), comprising a substrate (2), a buried heterojunction active layer (10) above said substrate, a current conduction region (4) above the active layer (10), one or more current confinement regions (20;120) formed over the substrate (2), at least one trench (25;125) formed in the current confinement region(s), said trench extending through said current confinement region(s) (20;120) towards the substrate (2) and the or each current confinement region being bounded on one side by the active layer (10), and on another side by said trench(es) (25;125) and the current confinement region(s) (20;120) and current conduction region (4) being arranged in use to channel electric current (5) to the active layer (10), wherein the or each current confinement region (20;120) includes a non-semiconducting insulating layer (19';119') that extends from the or each trench (25;125) towards the active layer (10) to restrict the flow of current (5) through the current confinement region (20;120).

2. A semiconductor device (101) as claimed in Claim 1, in which the insulating layer (119') is formed from one or more voids in the current confinement region (120).

3. A semiconductor device (1) as claimed in Claim 1, in which the insulating layer (19') is formed from an oxidised aluminium bearing layer.

4. A semiconductor device (1,101) as claimed in any preceding claim, in which the insulating layer (19';119') is capped at the or each trench (25;125) by a passivating layer (17;117) deposited over said trench(es).

5. A semiconductor device (1;101) as claimed in any preceding claim, in which the device includes a buried mesa structure (14,114) having one or more side walls (21,22) that rise above the substrate (2), with the active layer (10) extending to the side wall(s) (21,22) and the active layer (10) being proximate the insulating layer (19'; 119').

6. A semiconductor device (1;101) as claimed in any preceding claim, in which there is one non-semiconducting insulating layer (19';119') that extends from the or each trench (25;125) towards the active layer (10) to restrict the flow of current (5) through the current confinement region (20,120).

7. A semiconductor device (1;101) as claimed in any preceding claim, in which the thickness of the current confinement structure (20;120) is between 400 nm and 2 µm, and the thickness of the insulating layer (19';119') is between 50 nm and 250 nm.

8. A semiconductor device (1;101) as claimed in any previous claim, in which the device is a buried heterostructure laser diode device.

9. A method of forming semiconductor device (1;101) comprising an active layer (10), a current conduction region (4), and one or more current confinement regions (20;120), the or each current confinement region being bounded on one side by the active layer (10) and the current conduction region (4) and current confinement region(s) (20;120) being arranged in use to channel electric current (5) to the active layer (10), wherein the method comprises the steps of:
i) growing upon a semiconductor substrate (2) a plurality of semiconductor layers including the active layer (10) and the current conduction region (4) by which electric current (5) may be applied to the active layer (10) ;
ii) growing adjacent the active layer (10) a current blocking structure (20;120), said structure being formed from a plurality of semiconductor layers (7,18,19; 107,118,119);
iii) forming at least one trench (25;125) in the current confinement structure (20;120) towards the substrate (2) to expose within said structure one or more of said plurality of semiconductor layers (7,18,19;107,118,119);
iv) applying a reagent to said exposed semiconductor layer(s) in order to transform said one or more (19;119) of said layer(s) into a non-semiconductor insulating layer (19';119'), said insulating layer in use restricting the flow of current (5) through the current confinement structure (20;120).

10. A method as claimed in Claim 9, in which said reagent reacts with one or more (19;119) of said exposed semiconductor layers starting at the trench (25;125) and moving towards the active layer (10).

11. A method as claimed in Claim 9 or Claim 10, in which the insulating layer (119') is formed from one or more voids in the current confinement structure (120), and the method includes the step of using said reagent to etch away at least partially one or more (119) of said exposed semiconductor layers to produce said void(s) (119').

12. A method as claimed in Claim 9 or Claim 10, in which said exposed semiconductor layer(s) includes an aluminium-bearing semiconductor composition (19), and the method includes the step of using said reagent to oxidise at least partially said aluminium-bearing composition (19) to produce an aluminium oxide insulating layer (19').

13. A method as claimed in any of Claims 9 to 12, in which following step iv) the method includes the step of depositing over the or each trench (25;125) a passivating layer (17,117).

14. A method as claimed in any of Claims 9 to 13, in which the device (1,101) includes a buried mesa structure (14,114) having one or more side walls (21;22) that rise above the substrate (2), with the active layer (10) extending to the side wall(s) (21,22) and the active layer (10) being proximate the insulating layer (19';119').
